# EUROPÄISCHE PATENTSCHRIFT

(11) **EP 3 850 743 B1**
(45) Veröffentlichungstag und Bekanntmachung des Hinweises auf die Patenterteilung: **14.09.2022**
(21) Anmeldenummer: 19801695.8
(22) Anmeldetag: 28.10.2019
(51) Int. Cl.: H02M 7/00, H01L 23/367, H01M 10/44, H02M 1/36, H02H 9/00, H02J 7/34, H05K 7/20, H02J 1/00

(54) **GLEICHSTROMSCHALTER**
DC CURRENT SWITCH
COMMUTATEUR À COURANT CONTINU

(30) Priorität: 08.11.2018 EP 18205124
(43) Veröffentlichungstag der Anmeldung: 21.07.2021
(73) Patentinhaber: Siemens Aktiengesellschaft, 80333 München (DE)
(72) Erfinder: LAGER, Michael, 91074 Herzogenaurach (DE); HANDT, Karsten, 92348 Berg (DE); HÄNSEL, Stefan, 91056 Erlangen (DE)
(86) Internationale Anmeldenummer: PCT/EP2019/079325
(87) Internationale Veröffentlichungsnummer: WO 2020/094435

(56) Entgegenhaltungen:
- EP-A2- 2 672 361
- CN-A- 106 981 858
- CN-A- 107 994 277
- CN-U- 202 949 371
- DE-A1-102010 007 452
- DE-A1-102012 001 119
- RU-U1- 17 658
- US-A1- 2015 084 404

## Beschreibung

Die Erfindung betrifft eine Vorrichtung zum Koppeln zweier quell- und lastseitige Kapazitäten umfassenden Gleichstromnetze mittels eines Gleichstromschalters.

Gleichstromnetze, auch als DC-Netze bezeichnet, umfassen häufig große Kapazitäten, wie z.B. Zwischenkreiskondensatoren von Umrichtern. Werden zwei quell- und lastseitige Kapazitäten umfassende Gleichstromnetze miteinander verbunden, wobei eine der Kapazitäten bereits auf Betriebsspannung liegt, während die in dem anderen Gleichstromnetz noch entladen ist, treten bei einer direkten Verbindung der beiden Gleichstromnetze sehr hohe Ausgleichsströme auf, die den Nennstrom deutlich überschreiten können.

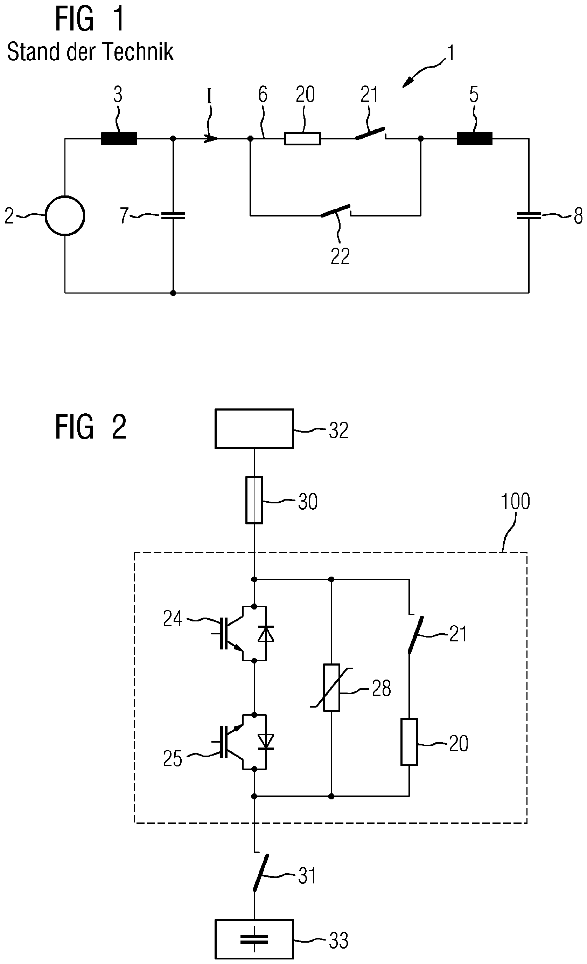

Um diese Ströme in ihrer Höhe zu begrenzen, erfolgt die Verbindung zweier quell- und lastseitiger Kapazitäten umfassenden Gleichstromnetze über geeignete Schaltvorrichtungen, wie dies im elektrischen Ersatzschaltbild der Figur 1 gezeigt ist. Solche Schaltvorrichtungen können auch als Gleichstromschalter oder "DC breaker" bezeichnet sein.

Fig. 1 zeigt das elektrische Ersatzschaltbild einer Schaltvorrichtung 1, welche über eine quellseitige Induktivität 3 mit einer Gleichspannungsquelle 2 verbunden ist. Parallel zu der Serienschaltung aus der Gleichspannungsquelle 2 und der quellseitigen Induktivität 3 ist eine quellseitige Kapazität 7 vorgesehen. Ausgangsseitig ist die Schaltvorrichtung 1 über eine lastseitige Induktivität 5 mit einer lastseitigen Kapazität 8 verbunden. Die quell- und lastseitigen Induktivitäten 3, 5 müssen nicht zwingend physikalische Komponenten der beiden über die Schaltvorrichtung 1 verbundenen Gleichspannungsnetze darstellen. Die quell- und lastseitigen Induktivitäten 3, 5 können auch Leitungsinduktivitäten sein. Die quell- und lastseitigen Kapazitäten 7, 8 sind z.B. Zwischenkreiskondensatoren von nicht dargestellten Umrichtern.

In der in Fig. 1 gezeigten, bekannten Variante einer Schaltvorrichtung 1 wird die Verbindung zwischen den beiden Gleichspannungsnetzen zunächst über einen Ladewiderstand 20 hergestellt. Der Ladewiderstand 20 ist in Serie zu einem Schaltelement 21 verschaltet und dient dazu, den Strom I zu begrenzen und eine Beschädigung der Komponenten zu vermeiden. Erst, wenn sich die Spannung zwischen den beiden Schienen der Gleichstromnetze soweit angenähert hat, dass eine niederohmige Verbindung möglich ist, wird der Ladewiderstand 20 mit einem Hauptschalter 22 überbrückt. Der Schalter 21 wird auch als Vorlade-Schalter bezeichnet. Nachteilig an bekannten Schaltvorrichtungen ist, dass der Vorlade-Widerstand erhebliche Mengen an Wärme produziert. Bei einem einzelnen Schaltvorgang ist die Wärmemenge aber vorhersehbar und so kann der Vorlade-Widerstand geeignet zu den anderen Komponenten der Schaltvorrichtung wie Leistungshalbleiter angeordnet werden, um diese nicht zu schädigen. Es ist aber möglich, dass aufgrund äußerer Umstände die Schaltvorrichtung mehrfach hintereinander aus- und eingeschaltet wird, d.h. der hohe Ausgleichsstrom mehrfach hintereinander auftritt. In solchen möglicherweise auch durch menschliche Bedienung auftretenden Fällen ist die erzeugte Wärmemenge nicht mehr vorhersehbar und eine Schädigung der den Vorlade-Widerstand umgebenden Elemente der Schaltvorrichtung ist nicht ausgeschlossen.

Die Kühlung von Vorlade-Widerständen ist Gegenstand von beispielsweise CN202949371U und CN107994277.

Es ist Aufgabe der vorliegenden Erfindung, einen Gleichstromschalter zum Koppeln zweier Gleichstromnetze anzugeben, der baulich und/oder funktionell verbessert ist. Diese Aufgabe wird gelöst durch eine Vorrichtung mit den Merkmalen von Anspruch 1.

Der erfindungsgemäße Gleichstromschalter zum Koppeln zweier Gleichstromnetze umfasst einen oder mehrere Leistungshalbleiterschalter, einen Vorlade-Widerstand zur Strombegrenzung bei Einschaltvorgängen und einen metallischen Kühlkörper zur Entwärmung des

Leistungshalbleiterschalters und des Vorlade-Widerstands. Dabei ist der Vorlade-Widerstand inmitten des Kühlkörpers in einer Aussparung im Kühlkörper angeordnet.

Der Kühlkörper umfasst dabei durch innenliegende Kühlrippen gebildete Kühlkanäle, die sich zwischen einer ersten und zweiten Außenfläche des Kühlkörpers erstrecken, wobei der oder die Leistungshalbleiterschalter auf einer dritten Außenfläche des Kühlkörpers angeordnet sind. Die Aussparung schließlich erstreckt sich von einer von der dritten Außenfläche abgewandten Außenfläche des Kühlkörpers in den Kühlkörper hinein.

Das Gleichstromnetz umfasst dabei insbesondere lastseitige Kapazitäten, möglicherweise aber auch quellseitige Kapazitäten und auch beidseitige Induktivitäten wie beispielsweise Leitungsinduktivitäten.

Für die Erfindung wurde erkannt, dass eine optimale Unterbringung des Vorlade-Widerstands gegeben ist, wenn der Vorlade-Widerstand innerhalb des für die Vorrichtung ohnehin vorhandenen Kühlkörpers angeordnet ist. Dabei ist eine Aussparung im Kühlkörper vorgesehen, in der der Vorlade-Widerstand angeordnet ist. Die Aussparung bezeichnet dabei einen Hohlraum, in dem die ansonsten typischerweise vorhandenen Kühlrippen oder -kanäle entfernt worden sind oder nicht vorhanden sind. Zweckmäßig führt die Aussparung an eine Oberfläche des Kühlkörpers. Es ist aber auch möglich, dass die Aussparung ausschließlich innerhalb des Kühlkörpers liegt. Ein Einsetzen des Vorlade-Widerstands ist dabei beispielsweise möglich, indem der Kühlkörper aus zwei Elementen zusammengesetzt wird. Durch die Anordnung im Kühlkörper wird sämtliche entstehende Wärme im Vorlade-Widerstand nicht an die umgebende Elektronik wie beispielsweise die Leistungshalbleiter, sondern direkt an den Kühlkörper abgegeben. Dadurch ist auch bei hoher Wärmeentwicklung des Vorlade-Widerstands, also auch bei mehrmaligem Einschalten, stets eine gute Wärmeabfuhr gegeben und die Möglichkeit der Beeinträchtigung anderer Elemente des Gleichstromschalters weitestgehend minimiert.

Besonders vorteilhaft ist dabei, dass der Vorlade-Widerstand nur zum Vorladen und nicht im Normalbetrieb verwendet wird und daher, obwohl die Kühlleistung des Kühlkörpers mitverwendet wird, die Kühlleistung im Normalbetrieb nicht verringert.

Vorteilhafte Ausgestaltungen des erfindungsgemäßen Gleichstromschalters gehen aus den von Anspruch 1 abhängigen Ansprüchen hervor. Dabei kann die Ausführungsform nach Anspruch 1 mit den Merkmalen eines der Unteransprüche oder vorzugsweise auch mit denen aus mehreren Unteransprüchen kombiniert werden. Demgemäß können für den Gleichstromschalter noch zusätzlich folgende Merkmale vorgesehen werden:
- Der Gleichstromschalter kann in für sich genommen bekannter Weise Lüfter zur aktiven Belüftung des Kühlkörpers umfassen. Durch den erzwungenen Luftfluss wird die Wärmeabfuhr aus dem Gleichstromschalter heraus deutlich verbessert.
- Es ist vorteilhaft, wenn der Kühlkörper den Vorlade-Widerstand umschließt. Mit anderen Worten ist die Aussparung so gestaltet, dass der Vorlade-Widerstand so in den Kühlkörper eingebracht werden kann, dass er von den äußeren Abmessungen des Kühlkörpers vollständig eingeschlossen ist. Vorteilhaft geht so nahezu sämtliche Wärmeabgabe in Form von Strahlung oder erhitzter Luft in alle Richtungen direkt in den Kühlkörper über und kann abgeführt werden. Andere Bauelemente wie beispielsweise auch das Gehäuse des Gleichstromschalters werden hingegen nur geringfügig von der Erhitzung des Vorlade-Widerstands beeinflusst.
- Die Aussparung kann so gestaltet sein, dass ein Einschieben des Vorlade-Widerstands in den Kühlkörper in Richtung der Luftströmung im Kühlkörper ermöglicht ist. Mit anderen Worten kann bei einem rohrartigen Kühlkörper die Aussparung von einem Ende des Rohrs aus in das Rohr hinein verlaufen. Ist der Vorlade-Widerstand beispielsweise auf einer Platine angeordnet, dann kann ein Teil der Kühlrippen derart ausgestaltet sein, dass sie als Schienen für das Einschieben der Platine dienen.
- Der Gleichstromschalter kann eine oder mehrere Temperatur-Messeinrichtungen zur Bestimmung der Kühlkörper-Temperatur umfassen, wobei die Vorrichtung ausgestaltet ist, eine aktive Belüftung bei Überschreiten einer Schwelltemperatur vorzunehmen. Mit anderen Worten wird ein Lüfter bei Überschreiten der Schwelltemperatur eingeschaltet. Bekanntermaßen ist es alternativ möglich, die Lüfterdrehzahl kontinuierlich zu regeln oder eine Kombination beider Möglichkeiten vorzusehen. Vorteilhaft wird dadurch Erwärmungen des Vorlade-Widerstands auch direkt durch eine Verstärkung der Entwärmung begegnet.
- Die elektrische Beschaltung des Gleichstromschalters kann einen ersten Strompfad mit wenigstens einem Leistungshalbleiter und einen zweiten, zum ersten Strompfad parallel geschalteten Strompfad mit einer Serienschaltung aus einem Vorlade-Schalter und dem Vorlade-Widerstand umfassen. Insbesondere können im ersten Strompfad zwei antiseriell in Serie angeordnete Leistungshalbleiter vorhanden sein. In diesem Fall werden die Leistungshalbleiter zweckmäßig jeweils mit einer Inversdiode betrieben, um den Stromfluss für beide Richtungen zu ermöglichen. Alternativ können auch rückwärtssperrende IBGTs in Antiparallelschaltung eingesetzt werden. Dabei sind die beiden rückwärtssperrenden IBGTs in einer Parallelschaltung angeordnet und so ausgerichtet, dass der erste abschaltbare Halbleiterschalter den Strom mit einer ersten Polarität führen kann und der zweite abschaltbare Halbleiterschalter den Strom mit entgegengesetzter Polarität führen kann. Neben rückwärtssperrenden IGBTs können auch andere beliebige rückwärtssperrende abschaltbare Halbleiterschalter in einer Antiparallelschaltung angeordnet werden. Der oder die Leistungshalbleiter bewirken die eigentliche Trennung oder Verbindung der Gleichstromnetze, während der Vorlade-Widerstand mittels des Vorlade-Schalters für Einschaltvorgänge zugeschaltet wird. Vorteilhaft bei der antiseriellen Anordnung ist, wenn die antiparallele Diode in den Chip des Transistors integriert ist. Ein solcher Schalter wird auch als rückwärtsleitender Schalter bezeichnet. Weiter ist es möglich, im Fall eines MOSFET oder JFET den Kanal in beide Stromrichtungen zu betreiben (antiparallele Anordnung).
- Der Gleichstromschalter kann ein Bauelement für den Überspannungsschutz, insbesondere einen Varistor umfassen. Dieser ist zweckmäßig in einem dritten Strompfade angeordnet, der parallel zum ersten und zweiten Strompfad geschaltet ist.
- Die Kühlleistung des Kühlkörpers muss weiterhin für den Gleichstromschalter ausreichend bemessen sein. Eine verringerte Kühlleistung durch die Aussparung im Kühlkörper kann daher dadurch ausgeglichen sein, dass der Kühlkörper in seinen Außenmaßen vergrößert ist gegenüber einem bekannten Gleichstromschalter.
- Alternativ zur Luftkühlung kann der Gleichstromschalter auch eine Wasserkühlung umfassen.
- Bevorzugt handelt es sich bei den Leistungshalbleitern um Si-IGBTs, SiC-MOSFETs oder GaN-FETs handeln.

Die beschriebene Schaltvorrichtung ist insbesondere für die Verwendung in einem Gleichspannungsnetz mit einer Spannung von zwischen 100 V und 1500 V vorgesehen. Die vorgesehenen Nennströme liegen im Bereich von 8 A bis 2000 A. Eine weitere Ausgestaltung sieht vor, dass der Gleichstromschalter der hier beschriebenen Art als kurzschlussfester Leistungsschalter verwendet wird.

Weitere Vorteile und Merkmale sind der folgenden Beschreibung von Ausführungsbeispielen anhand der Figuren zu entnehmen. In den Figuren bezeichnen gleiche Bezugszeichen gleiche Bauteile und Funktionen.

Es zeigen:
Figur 2 das elektrische Ersatzschaltbild eines Gleichstromschalters mit einem Vorlade-Widerstand,
Figur 3 ein Schnittbild durch den Kühlkörper des Gleichstromschalters mit dem Vorlade-Widerstand in Seitenansicht,
Figur 4 eine Vorderansicht des Kühlkörpers,
Figur 5 eine perspektivische Ansicht des Kühlkörpers mit dem Vorlade-Widerstand.

Figur 2 zeigt das elektrische Ersatzschaltbild einer beispielhaften Gleichstromschalter 100, die in umgebende Gleichstromnetze integriert ist. Zum quellseitigen Ausgang hin ist der Gleichstromschalter 100 über eine Sicherung 30 mit einem DC-Netzwerk 32 verbunden. Dieses DC-Netzwerk 32 kann beispielsweise ein industrielles DC-Netzwerk wie das in einer Fabrik sein. Das DC-Netzwerk 32 kann einen Generator, eine Photovoltaikanlage, ein Energieversorgungsnetz oder Energiespeicher umfassen. Die Sicherung 30 gewährleistet den Schutz des Verbrauchers bei einer hohen Strombelastung unabhängig von dem Gleichstromschalter 100. Lastseitig ist der Gleichstromschalter 100 über einen Last-Trennschalter 31 mit einer Last 33 verbunden, die einen kapazitiven Anteil aufweist, beispielsweise einen Umrichter mit einem Zwischenkreis-Kondensator. Der Gleichstromschalter 100 dient dazu, die elektrischen Last 33 vom DC-Netzwerk 32 zu trennen und einen Strom abzuschalten.

Der Gleichstromschalter 100 selbst umfasst einen ersten Strompfad mit zwei antiseriell geschalteten IGBTs 24, 25. Das bedeutet, dass ein Stromfluss durch den ersten IGBT 24 durch die zum zweiten IGBT 25 antiparallele Diode fließt. Bei entgegengesetzter Polarität, d.h. bei umgekehrter Stromflussrichtung fließt der Strom durch den zweiten IGBT 25 und durch die zum ersten IGBT 24 antiparallele Diode. Eine alternative, antiparallele Schaltung der beiden IGBTs 24, 25 ist hier nicht dargestellt. In diesem Fall kann auf Dioden verzichtet werden, jedoch müssen die Halbleiterschalter dann rückwärts sperrfähig sein. Der erste Strompfad wird im eingeschalteten Zustand des Gleichstromschalters 100 im Normalbetrieb verwendet, d.h. im eingeschalteten Zustand sind die beiden IGBTs 24, 25 leitend geschaltet. Soll der Gleichstromschalter 100 eine Trennung der DC-Verbindung vornehmen, werden die beiden IGBTs 24, 25 abgeschaltet.

Parallel zum ersten Strompfad ist ein zweiter Strompfad vorhanden, der eine Serienschaltung eines Vorlade-Schalters 21 mit einem Vorlade-Widerstand 20 umfasst. Der Vorladewiderstand wird nur für Einschaltvorgänge verwendet und somit nur mittels des Vorlade-Schalters 21 zugeschaltet, wenn der Gleichstromschalter 100 die DC-Verbindung einschalten soll. Wenn sich die Spannung an der Kapazität in der Last 33 weitgehend an die Spannung des DC-Netzwerks 32 angeglichen hat, also der fließende Ausgleichsstrom nicht mehr zu hoch ist, werden die IGBTs 24, 25 eingeschaltet.

Wiederum parallel zum ersten und zweiten Strompfad ist ein dritter Strompfad vorhanden, der eine Überspannungsbegrenzung, in diesem Beispiel einen Varistor 28 umfasst. Zur Messung des Stromes durch den Gleichstromschalter 100 dient eine nicht gezeigte Strommessvorrichtung, die innerhalb des Gleichstromschalters 100 oder außerhalb des Gleichstromschalters 100 angeordnet sein kann. Zur Ansteuerung der IGBTs 24, 25 dient eine nicht gezeigte Steuervorrichtung, die mit den Steueranschlüssen der IGBTs 24, 25 verbunden ist.

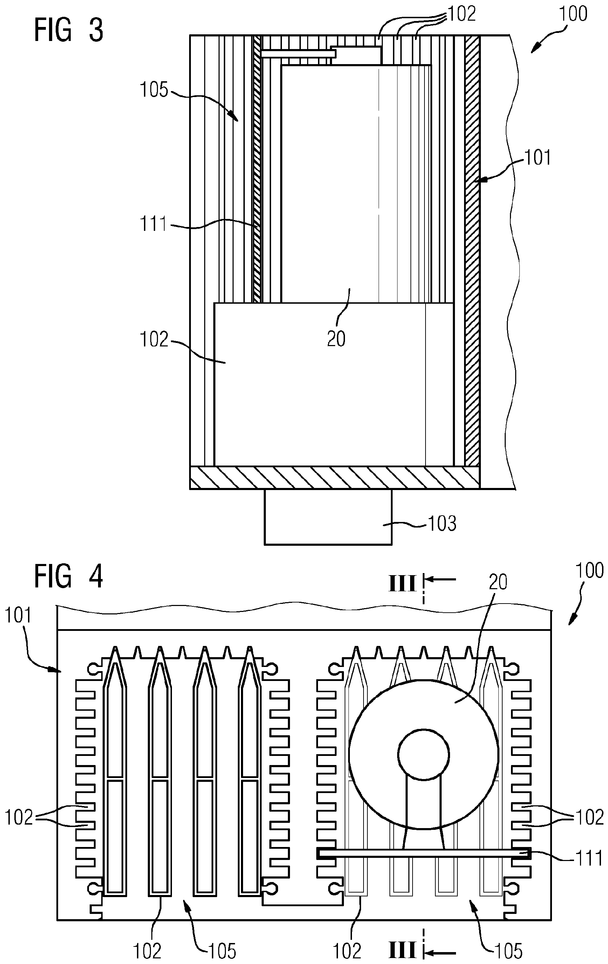

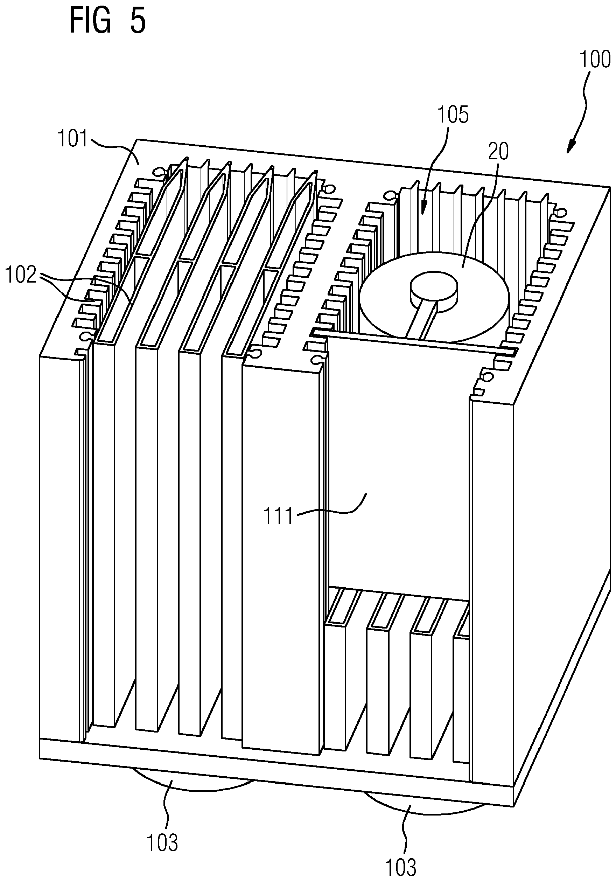

In den Figuren 3 bis 5 ist in Seitenansicht, Vorderansicht und perspektiver Ansicht gezeigt, wie der Vorlade-Widerstand 20 in den Gleichstromschalter 100 integriert ist. Der Gleichstromschalter 100 umfasst einen quaderförmigen Kühlkörper 101 mit einer Mehrzahl von unterschiedlich gestalteten Kühlrippen 102. Der Kühlkörper 101 umfasst zwei getrennte Luftkanäle, die von zwei Lüftern 103 aktiv belüftet werden. Die Lüfter 103 sind dazu an einem Ende des Kühlkörpers 101 angeordnet. Auf einer ersten Seite des Kühlkörpers 101 sind die elektronischen und elektrischen Aufbauten des Gleichstromschalters 100 angeordnet, also insbesondere die IGBTs 24, 25 auf entsprechenden Platinen, Stromschienen und weitere elektronische Bauelemente, beispielsweise zur Steuerung und für Anzeigeelemente.

In einen der beiden Kühlkanäle ist über einen Teil der Länge des Kühlkörpers 101 eine Aussparung 105 eingebracht, in der die Kühlrippen 102 teilweise entfernt sind. In diesem Beispiel sind die Kühlrippen 102 mittels Ausfräsen entfernt worden. Die Herstellung einer entsprechenden Aussparung 105 kann aber auch auf andere Weise erfolgen.

In der Aussparung 105 ist der Vorlade-Widerstand 20 angeordnet, der seinerseits auf einer Trägerplatine 111 aufgebracht ist. In diesem Beispiel umfasst der Kühlkanal an den Seiten verlaufende Kühlrippen, die auch im Bereich der Aussparung 105 erhalten sind und als Einschubschiene für die Trägerplatine 111 verwendet sind. Der Vorlade-Widerstand 20 ist dadurch inmitten des Kühlkörpers 101 angeordnet und wird nach mehreren Seiten von dem metallischen Material umschlossen. Vom Vorlade-Widerstand 20 abgegebene Wärme in Form von Strahlung oder erhitzter Luft trifft dadurch weitgehend auf das Material des Kühlkörpers 101 und kann effizient gespreizt und abtransportiert werden. Eine direkte Erwärmung oder gar Überhitzung von anderen Komponenten des Gleichstromschalters wie beispielsweise den IGBTs 24, 25 durch den Vorlade-Widerstand 20, wenn dieser im Bereich der Elektronik anstatt innerhalb des Kühlkörpers 101 angeordnet wäre, findet nicht statt.

Besonders vorteilhaft ist es, wenn die Lüfter 103 geregelt sind unter Verwendung von beispielsweise dem Signal eines Temperatursensors. Dann führt ein Wärmeeintrag durch den Vorlade-Widerstand 20 oder gar mehrere solche Wärmeeinträge in kurzer Zeit zu einer entsprechenden Reaktion der Lüfter 103 und somit zu einer optimalen Entwärmung, die an die Schaltvorgänge angepasst ist. Dadurch entfällt vorteilhaft ein überdimensionierter Vorlade-Widerstands 20, der beim Vorladen nur geringfügig erhitzt wird und bei mehrfachem Vorladen in kurzer Zeit trotzdem überhitzen könnte.

### Bezugszeichenliste

- 1: Schaltvorrichtung
- 2: Gleichspannungsquelle
- 3: quellseitige Induktivität
- 5: lastseitige Induktivität
- 6: aufzutrennende Leitung
- 7: quellseitige Kapazität
- 8: lastseitige Kapazität
- 20: Vorlade-Widerstand
- 21: Vorlade-Schalter
- 24,25: IGBT
- 28: Varistor
- 30: Sicherung
- 31: Last-Trennschalter
- 32: DC-Netzwerk
- 33: kapazitive Last
- 100: Gleichstromschalter
- 101: Kühlkörper
- 102: Kühlrippen
- 103: Lüfter
- 105: Aussparung
- 111: Träger-Platine
- I: Strom

## Patentansprüche

1. Gleichstromschalter (100) zum Koppeln zweier Gleichstromnetze (32), von denen ein lastseitiges Gleichstromnetz insbesondere lastseitige Kapazitäten (33) umfasst, umfassend
- einen oder mehrere Leistungshalbleiterschalter (24, 25),
- einen Vorlade-Widerstand (20) zur Strombegrenzung bei Einschaltvorgängen,
- einen metallischen Kühlkörper (101) zur Entwärmung des Leistungshalbleiters (24, 25) und des Vorlade-Widerstands (20), wobei der Kühlkörper (101) durch innenliegende Kühlrippen (102) gebildete Kühlkanäle umfasst, die sich zwischen einer ersten und zweiten Außenfläche des Kühlkörpers (101) erstrecken und wobei der Leistungshalbleiterschalter (24, 25) auf einer dritten Außenfläche des Kühlkörpers (101) angeordnet ist, **dadurch gekennzeichnet, dass** der Vorladewiderstand (20) inmitten des Kühlkörpers (101) in einer Aussparung (105) im Kühlkörper (101) angeordnet ist und nach mehreren Seiten von dem metallischen Material umschlossen ist, wobei die Aussparung (105) sich von einer von der dritten Außenfläche abgewandten Außenfläche des Kühlkörpers (101) in den Kühlkörper (101) hinein erstreckt.

2. Gleichstromschalter (100) nach Anspruch 1, bei dem der Kühlkörper (101) im Wesentlichen quaderförmig ist.

3. Gleichstromschalter (100) nach Anspruch 1 oder 2, bei dem sich die Aussparung parallel zu den Kühlkanälen in den Kühlkörper erstreckt.

4. Gleichstromschalter (100) nach einem der vorangehenden Ansprüche mit einem oder mehreren Lüftern (103) zur aktiven Belüftung des Kühlkörpers (103).

5. Gleichstromschalter (100) nach einem der vorangehenden Ansprüche, bei der der Kühlkörper (101) den Vorlade-Widerstand (20) umschließt.

6. Gleichstromschalter (100) nach einem der vorangehenden Ansprüche, bei der die Aussparung (105) so gestaltet ist, dass ein Einschieben des Vorlade-Widerstands (20) in den Kühlkörper (101) in Richtung der Luftströmung im Kühlkörper (101) ermöglicht ist.

7. Gleichstromschalter (100) nach Anspruch 6, bei der der Vorlade-Widerstand (20) auf einer Träger-Platine (111) angeordnet ist und ein Teil der Kühlrippen (102) derart ausgestaltet sind, dass sie als Schienen für das Einschieben der Träger-Platine (111) dienen.

8. Gleichstromschalter (100) nach einem der vorangehenden Ansprüche mit einer Temperatur-Messeinrichtung zur Bestimmung der Kühlkörper-Temperatur, wobei der Gleichstromschalter (100) ausgestaltet ist, eine aktive Belüftung bei Überschreiten einer Schwelltemperatur vorzunehmen.

9. Gleichstromschalter (100) nach einem der vorangehenden Ansprüche, bei dem die elektrische Beschaltung einen ersten Strompfad mit wenigstens einem Leistungshalbleiterschalter (24, 25) und einen zweiten, zum ersten Strompfad parallel geschalteten Strompfad mit einer Serienschaltung aus einem Vorlade-Schalter (21) und dem Vorlade-Widerstand (20) umfasst.

10. Gleichstromschalter (100) nach Anspruch 9, bei dem die elektrische Beschaltung zwei gegensinnig in Serie angeordnete Leistungshalbleiterschalter (24, 25) umfasst.

11. Gleichstromschalter (100) nach Anspruch 9, bei dem die elektrische Beschaltung zwei antiparallel angeordnete rückwärtssperrende Leistungshalbleiterschalter umfasst, insbesondere rückwärtssperrende IGBT.

12. Gleichstromschalter (100) nach einem der vorangehenden Ansprüche mit einem Bauelement für den Überspannungsschutz, insbesondere einem Varistor (28).

13. Gleichstromschalter (100) nach einem der vorangehenden Ansprüche mit einer Strommessvorrichtung und/oder einer Spannungsmessvorrichtung.

14. Gleichspannungssystem umfassend
- mindestens eine Energiequelle mit einer Gleichspannung,
- einen oder mehrere einen kapazitiven elektrischen Verbraucher (33) mit einem Gleichspannungsanschluss,
- einen oder mehrere Gleichstromschalter (100) nach einem der vorangehenden Ansprüche.

## Claims

1. DC switch (100) for coupling two DC networks (32), a load-side DC network of which comprises, in particular, load-side capacitors (33), said DC switch comprising:
- one or more power semiconductor switches (24, 25),
- a precharge resistor (20) for limiting current during switch-on processes;
- a metal heat sink (101) for extracting heat from the power semiconductor (24, 25) and the precharge resistor (20), wherein the heat sink (101) comprises cooling ducts which are formed by internal cooling fins (102) and extend between a first and a second outer surface of the heat sink (101), and wherein the power semiconductor switch (24, 25) is arranged on a third outer surface of the heat sink (101), **characterized in that** the precharge resistor (20) is arranged inside the heat sink (101) in a recess (105) in the heat sink (101) and is enclosed by the metal material on several sides, wherein the recess (105) extends from an outer surface of the heat sink (101) that faces away from the third outer surface into the heat sink (101).

2. DC switch (100) according to Claim 1, in which the heat sink (101) is substantially cuboidal.

3. DC switch (100) according to Claim 1 or 2, in which the recess extends parallel to the cooling ducts, into the heat sink.

4. DC switch (100) according to one of the preceding claims having one or more fans (103) for actively ventilating the heat sink (103).

5. DC switch (100) according to one of the preceding claims, in which the heat sink (101) encloses the precharge resistor (20) .

6. DC switch (100) according to one of the preceding claims, in which the recess (105) is designed such that it is possible to insert the precharge resistor (20) into the heat sink (101) in the direction of the air flow in the heat sink (101).

7. DC switch (100) according to Claim 6, in which the precharge resistor (20) is arranged on a carrier board (111) and some of the cooling fins (102) are configured in such a way that they serve as rails for inserting the carrier board (111) .

8. DC switch (100) according to one of the preceding claims having a temperature measuring device for determining the heat sink temperature, wherein the DC switch (100) is configured to perform active ventilation when a threshold temperature is exceeded.

9. DC switch (100) according to one of the preceding claims, in which the electrical circuitry comprises a first current path with at least one semiconductor switch (24, 25) and a second current path which is connected in parallel with the first current path and contains a series circuit comprising a precharge switch (21) and the precharge resistor (20).

10. DC switch (100) according to Claim 9, in which the electrical circuitry comprises two semiconductor switches (24, 25) arranged in series in opposition.

11. DC switch (100) according to Claim 9, in which the electrical circuitry comprises two reverse-blocking semiconductor switches arranged back-to-back in parallel, in particular reverse-blocking IGBTs.

12. DC switch (100) according to one of the preceding claims having a component for overvoltage protection, in particular a varistor (28).

13. DC switch (100) according to one of the preceding claims having a current measuring apparatus and/or a voltage measuring apparatus.

14. DC voltage system comprising
- at least one power source with a DC voltage,
- one or more one capacitive electrical loads (33) with a DC voltage connection,
- one or more DC switches (100) according to one of the preceding claims.

## Revendications

1. Sectionneur (100) à courant continu pour relier deux réseaux (32) à courant continu, dont un réseau à courant continu du côté de la charge comprend notamment des capacités (33) du côté de la charge, comprenant
- un ou plusieurs interrupteurs (24, 25) à semiconducteur de puissance,
- une résistance (20) de précharge pour limiter le courant lors d'opérations de mise en circuit,
- un dissipateur (101) métallique de chaleur pour évacuer de la chaleur du semiconducteur (24, 25) de puissance et de la résistance (20) de précharge, le dissipateur (101) de chaleur comprenant des canaux de refroidissement, qui sont formés d'ailettes (102) de refroidissement à l'intérieur et qui s'étendent entre une première et une deuxième surface du dissipateur (101) de chaleur, et dans lequel l'interrupteur (24, 25) à semiconducteur de puissance est monté sur une troisième surface extérieure du dissipateur (101) de chaleur,
**caractérisé en ce que** la résistance (20) de précharge est disposée au milieu du dissipateur (101) de chaleur dans un évidement (105) du dissipateur (101) de chaleur et est entourée de plusieurs côtés du matériau métallique, l'évidement (105) s'étendant d'une surface extérieure, non tournée vers la troisième surface extérieure, du dissipateur (101) de chaleur à l'intérieur du dissipateur (101) de chaleur.

2. Sectionneur (100) à courant continu suivant la revendication 1, dans lequel le dissipateur (101) de chaleur est de forme sensiblement parallélépipédique.

3. Sectionneur (100) à courant continu suivant la revendication 1 ou 2, dans lequel l'évidement s'étend parallèlement aux canaux de refroidissement du dissipateur de chaleur.

4. Sectionneur (100) à courant continu suivant l'une des revendications précédentes, comprenant un ou plusieurs ventilateurs (103) pour ventiler activement le dissipateur (103) de chaleur.

5. Sectionneur (100) à courant continu suivant l'une des revendications précédentes, dans lequel le dissipateur (101) de chaleur entoure la résistance (20) de précharge.

6. Sectionneur (100) à courant continu suivant l'une des revendications précédentes, dans lequel l'évidement (105) est conformé de manière à rendre possible une introduction de la résistance (20) de précharge dans le dissipateur (101) de chaleur dans la direction de l'écoulement de l'air dans le dissipateur (101) de chaleur.

7. Sectionneur (100) à courant continu suivant la revendication 6, dans lequel la résistance (20) de précharge est montée sur une platine (111) support et une partie des ailettes (102) de refroidissement sont conformées de manière à servir de rails pour l'introduction de la platine (111) support.

8. Sectionneur (100) à courant continu suivant l'une des revendications précédentes, comprenant un dispositif de mesure de la température pour la détermination de la température du dissipateur de chaleur, le sectionneur (100) à courant continu étant conformé pour effectuer une ventilation active si une température de seuil est dépassée.

9. Sectionneur (100) à courant continu suivant l'une des revendications précédentes, dans lequel le montage électrique comprend un premier trajet de courant ayant au moins un interrupteur (24, 25) à semiconducteur de puissance et un deuxième trajet de courant, qui est monté en parallèle avec le premier trajet de courant et qui a un circuit série composé d'un interrupteur (21) de précharge et de la résistance (20) de précharge.

10. Sectionneur (100) à courant continu suivant la revendication 9, dans lequel le montage électrique comprend deux interrupteurs (24, 25) à semiconducteur de puissance montés tête bêche en série.

11. Sectionneur (100) à courant continu suivant la revendication 9, dans lequel le montage électrique comprend deux interrupteurs à semiconducteur de puissance bloquant en inverse montés tête bêche, notamment des IGBT bloquants en inverse.

12. Sectionneur (100) de courant continu suivant l'une des revendications précédentes, comprenant un composant de protection vis-à-vis d'une surtension, notamment une varistance (28).

13. Sectionneur (100) de courant continu suivant l'une des revendications précédentes, comprenant un dispositif de mesure du courant et/ou un dispositif de mesure de la tension.

14. Système à tension continue, comprenant
- au moins une source d'énergie ayant une tension continue,
- un ou plusieurs consommateurs (33) électriques capacitifs ayant une borne de tension continue,
- un ou plusieurs sectionneurs (100) à courant continu suivant l'une des revendications précédentes.
